# EUROPÄISCHE PATENTANMELDUNG

(11) **EP 1 180 770 A1**
(43) Veröffentlichungstag der Anmeldung: **20.02.2002**
(21) Anmeldenummer: 01114680.0
(22) Anmeldetag: 19.06.2001
(51) Int. Cl.: G11C 11/16

(54) **MRAM-Anordnung**

(30) Priorität: 03.07.2000 DE 10032277
(71) Anmelder: Infineon Technologies AG, 81669 München (DE)
(72) Erfinder: Poechmueller, Peter, 81739 München (DE)
(74) Vertreter: Müller . Hoffmann & Partner Patentanwälte

(57) **Zusammenfassung**

Die Erfindung betrifft eine MRAM-Anordnung, bei der mehrere Speicherzellenblöcke (ZB1, ZB2) mit jeweils voneinander verschiedenen Betriebsspannungen versorgt sind, so daß die Chip-Spannungsversorgung von etwa 2 bis 3 V besser ausgenutzt werden kann.

## Beschreibung

Die vorliegende Erfindung betrifft eine MRAM-Anordnung mit einem Speicherchip, der zwischen einer Spannungsversorgung und einem Speicherzellenfeld eine Spannungs-Konstantreglereinrichtung aufweist, die über Wort- und/oder Bitleitungen eine feste Betriebsspannung an das Speicherzellenfeld liefert, wobei zwischen dem mit der Spannungs-Konstantreglereinrichtung verbundenen Eingang der Wort- und/oder Bitleitungen und deren Ausgang ein Spannungsabfall auftritt.

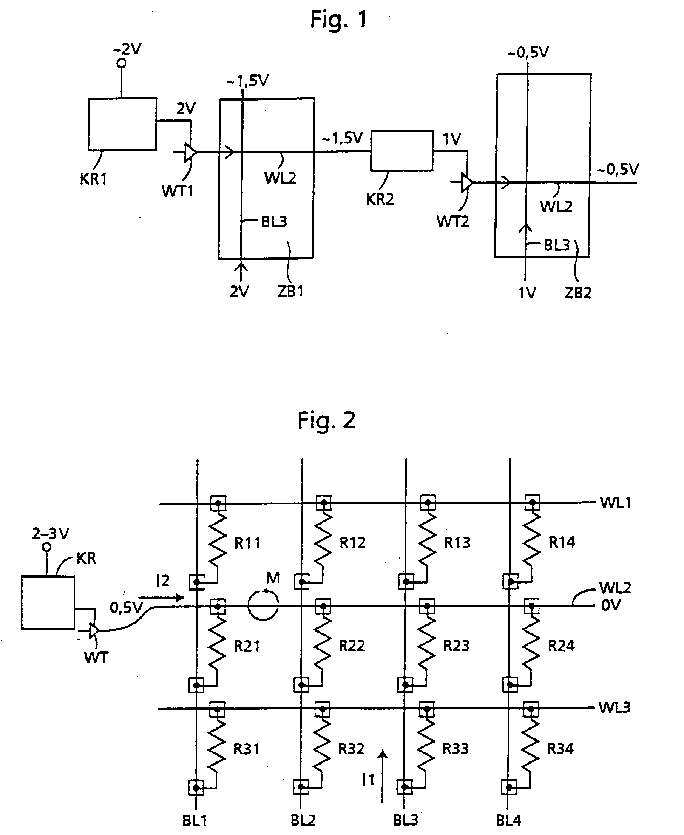

Fig. 2 zeigt den Aufbau des Speicherzellenfeldes eines herkömmlichen MRAMs. Dieser besteht aus Wortleitungen WL1, WL2, WL3, ... und Bitleitungen BL1, BL2, BL3, BL4, ..., welche die Wortleitungen WL1, WL2, WL3, ... im wesentlichen senkrecht kreuzen. An den Kreuzungsstellen zwischen den Wortleitungen WL1, WL2, WL3, ... und den Bitleitungen BL1, BL2, BL3, BL4, ... liegen Speicherzellen, die jeweils durch einen Widerstand R11, R12, ..., R33, R34, allgemein Rij, angedeutet sind.

Dieser Widerstand Rij repräsentiert die Strecke eines Tunnelstromes, der zwischen einer Wortleitung, beispielsweise der Wortleitung WL2, und einer Bitleitung, beispielsweise der Bitleitung BL3 fließt, wenn eine Spannungsdifferenz zwischen dieser Wortleitung WL2 und dieser Bitleitung BL3 vorliegt. Abhängig von einem in die Speicherzelle geschriebenen Magnetfeld nimmt dann dieser Tunnelstrom einen größeren oder kleineren Wert an. Mit anderen Worten, die Speicherzelle kann als Binärwiderstand aufgefaßt werden, der mit einem größeren oder kleineren Widerstandswert programmiert ist. Diesen beiden Widerstandswerten kann dann die Informationseinheit "1" oder "0" zugeordnet werden.

Das Programmieren einer Speicherzelle erfolgt also durch Anlegen eines Magnetfeldes. Um nun eine Speicherzelle auf einen Wert "0" oder "1" zu programmieren, muß das Magnetfeld gewisse Schwellenwerte überschreiten. Dabei ist zu beachten, daß die Speicherzelle eine magnetische Hysterese hat.

Wie in Fig. 2 angedeutet ist, bewirkt beispielsweise ein in der Wortleitung WL2 fließender Gleichstrom I2 ein Magnetfeld M um diese Wortleitung WL2. Die Richtung des Magnetfeldes M ist dabei umgekehrt, wenn der Strom I2 in umgekehrter Richtung fließt. Die Richtung des Magnetfeldes M gibt nun an, ob eine "1" oder eine "0" in eine Speicherzelle eingeschrieben wird. Es sei nun angenommen, daß der Strom I2 in der Wortleitung WL2 die Informationseinheit "1" bedeutet. Alle Speicherzellen, die mit der Wortleitung WL2 verbunden sind, also die Speicherzellen mit den Widerständen R21, R22, R23 und R24 sind durch den Strom I2 mit dem Magnetfeld M beaufschlagt. Die Hysterese der Speicherzellen mit den Widerständen R21, R22, R23 und R24 bewirkt nun, daß das Magnetfeld M allein noch nicht ausreichend stark ist, um alle diese Speicherzellen aus einem "0"-Zustand in einen "1"-Zustand zu bringen. Vielmehr muß zusätzlich noch eine Bitleitung, beispielsweise die Bitleitung BL3, mit einem Strom I1 angesteuert werden, um an der Schnittstelle der Bitleitung BL3 mit der Wortleitung WL2 ein Magnetfeld zu erzeugen, das durch Überlagerung der durch die Ströme I1 und I2 erzeugten Magnetfelder ausreichend stark ist, um an der Schnittstelle, also im Widerstand R23, beispielsweise den "0"-Zustand in einen "1"-Zustand zu überführen. Mit anderen Worten, durch Ansteuerung von ausgewählten Wortleitungen WLi und ausgewählten Bitleitungen BLj ist es möglich, die Speicherzellen an den Schnittstellen dieser Wort- und Bitleitungen - abhängig von der Richtung des durch die jeweiligen Ströme erzeugten Magnetfeldes - in einen "0"- oder einen "1"-Zustand zu programmieren.

Ein nun bei MRAMs allgemein auftretendes Problem liegt in dem relativ hohen Leistungs- bzw. Energieverbrauch. Dieser beruht darauf, daß der Spannungsabfall längs einer MRAM-Zelle aus technologischen Gründen in der Regel 0,5 V nicht überschreitet. Dies hat an sich den Vorteil, daß die Wortleitungen und Bitleitungen bei einer relativ niedrigen Spannung von beispielsweise 0,5 V arbeiten. Die Versorgungsspannung auf einem Speicherchip ist aber wesentlich höher und liegt insbesondere bei 2 bis 3 V. Aus diesem Grund wird bei den bestehenden MRAM-Anordnungen zwischen der Spannungsversorgung von 2 bis 3 V und dem eigentlichen Speicherzellenfeld mit den Wortleitungen WLi und den Bitleitungen BLj eine Spannungs-Konstantreglereinrichtung KR vorgesehen, wie dies in Fig. 2 für die Wortleitung WL2 gezeigt ist. Diese Spannungs-Konstantreglereinrichtung transformiert die Versorgungsspannung von 2 bis 3 V in 0,5 V, welche über einen Wortleitungstreiber WT dann der Wortleitung WL2 aufgeprägt werden. Die übrigen Wortleitungen WL1, WL3, ... sind mit entsprechenden Spannungs-Konstantreglereinrichtungen versehen.

Da in dem Speicherzellenfeld 0,5 V an jeder Wortleitung abfallen, liegen am Ausgang der Wortleitungen, also beispielsweise der Wortleitung WL2, dann 0 V an, wie dies in Fig. 2 angedeutet ist.

Die Transformation der Versorgungsspannung von 2 bis 3 V in 0,5 V bedeutet nun, daß der größte Teil der Energie bzw. Leistung "vergeudet" wird, da von den der Spannungs-Konstantreglereinrichtung KR zur Verfügung gestellten 2 bis 3 V an Versorgungsspannung lediglich 0,5 V, also zwischen 16 % und 25 %, tatsächlich genutzt werden, während die übrigen 84 bis 75 % ungenutzt sind.

Eine derartige Energie- bzw. Leistungsbilanz ist aus verständlichen Gründen äußerst unbefriedigend und sollte möglichst vermieden werden. Dennoch gibt es für dieses Problem bisher keine Lösung, da die MRAM-Zellen eben lediglich etwa 0,5 V benötigen, während die allgemein Speicherchip-Spannungsversorgung Werte von 2 bis 3 V hat.

Es ist daher Aufgabe der vorliegenden Erfindung, eine MRAM-Anordnung zu schaffen, bei der die Speicherchip-Spannungsversorgung besser ausgenutzt wird, so daß praktisch keine Verlustleistungen auftreten.

Diese Aufgabe wird bei einer MRAM-Anordnung der eingangs genannten Art erfindungsgemäß dadurch gelöst, daß das Speicherzellenfeld in mehrere Speicherzellenblöcke unterteilt ist und die Speicherzellenblöcke von der Spannungs-Konstantreglereinrichtung mit jeweils voneinander verschiedenen festen Betriebsspannungen versorgt sind. Dabei kann die Spannungs-Konstantreglereinrichtung aus mehreren Spannungs-Konstantreglern bestehen und jedem Speicherzellenblock jeweils ein Spannungs-Konstantregler zugeordnet sein. In bevorzugter Weise ist der Ausgang der Wort- und/oder Bitleitungen eines ersten Speicherzellenblockes als Spannungsversorgung mit dem Eingang des Spannungs-Konstantreglers eines zweiten Speicherzellenblockes und so weiter verbunden.

Die MRAM-Anordnung ist also erfindungsgemäß in mehrere Speicherzellenblöcke unterteilt, wobei in jedem einzelnen Speicherzellenblock die Wortleitungen und die Bitleitungen mit von den anderen Speicherzellenblöcken verschiedenen Betriebsspannungen angesteuert sind.

Nachfolgend wird die Erfindung anhand der Zeichnungen näher erläutert. Es zeigen:
- Fig. 1: ein Blockschaltbild der erfindungsgemäßen MRAM-Anordnung und

- Fig. 2: ein schematisches Schaltbild einer bestehenden MRAM-Anordnung.

Die Fig. 2 ist bereits eingangs erläutert worden. In den Figuren werden für einander entsprechende Bauteile jeweils die gleichen Bezugszeichen verwendet.

Fig. 1 zeigt Zellenblöcke ZB1 und ZB2, die jeweils in gleicher Weise wie das Speicherzellenfeld von Fig. 2 mit den Wortleitungen WL1, WL2, WL3, ... und den Bitleitungen BL1, BL2, BL3, BL4, ... sowie den einzelnen, aus den Widerständen R11, R12, ... R33, R34 gebildeten Speicherzellen aufgebaut sind. Als Beispiel sind hier lediglich die Wortleitungen WL2 und die Bitleitungen BL3 in diesen Speicherzellenblöcken ZB1 und ZB2 veranschaulicht.

Die Speicherchip-Spannungsversorgung soll hier - wie üblich - eine Versorgungsspannung von etwa 2,5 V liefern. Diese Versorgungsspannung von etwa 2,5 V wird einem ersten Spannungs-Konstantregler KR1 zugeführt, der daraus eine konstante Spannung von 2 V liefert. Diese Spannung von 2 V wird über einen ersten gesteuerten Wortleitungstreiber WT1 der Wortleitung WL2 des Speicherzellenblockes ZB1 zugeführt. Die übrigen Wortleitungen sowie Bitleitungen sind mit entsprechenden Spannungs-Konstantreglern an ihrem jeweiligen Eingang versehen.

Am Ausgang der Wortleitung WL2 liegt dann infolge des Spannungsabfalles von etwa 0,5 V eine Spannung von ungefähr 1,5 V. Diese Spannung von 1,5 V wird einem zweiten Spannungs-Konstantregler KR2 zugeführt. Dieser zweite Spannungs-Konstantregler erzeugt aus der "Versorgungsspannung" von ungefähr 1,5 V dann eine konstante Spannung von 1 V, die über einen zweiten Wortleitungstreiber WT2 als "+1 V" an die Wortleitung WL2 des zweiten Speicherzellenblockes ZB2 angelegt wird.

Ähnliche Spannungs-Konstantregler wie der Spannungs-Konstantregler KR2 sind eingangsseitig an die Ausgänge der übrigen Wortleitungen und Bitleitungen des Speicherzellenblockes ZB1 und ausgangsseitig an die Eingänge der übrigen Wortleitungen und Bitleitungen des Speicherzellenblockes ZB2 angeschlossen. Dadurch werden sämtliche Wortleitungen und Bitleitungen des Speicherzellenblockes ZB2 mit konstanten 1 V bzw. -1 V versorgt. An den Ausgängen der Wortleitungen und Bitleitungen des Speicherzellenblockes ZB2 stehen dann jeweils etwa 0,5 V zur Verfügung, die gegebenenfalls noch nach einer weiteren Spannungs-Konstantregelung einem dritten Speicherzellenblock zugeführt werden können.

Aus dem obigen Ausführungsbeispiel ist zu ersehen, daß durch die Erfindung wenigstens ohne weiteres eine doppelte Ausnutzung der zur Verfügung stehenden Versorgungsspannung von etwa 2,5 V möglich ist, wenn in jedem Speicherzellenblock ein Spannungsabfall von 0,5 V angenommen wird und für jeden Speicherzellenblock eine sichere konstante Spannung gewährleistet sein muß.

## Patentansprüche

1. MRAM-Anordnung mit einem Speicherchip, der zwischen einer Spannungsversorgung (2 bis 3 V) und einem Speicherzellenfeld eine Spannungs-Konstantreglereinrichtung (KR) aufweist, die über Wort- und/oder Bitleitungen (WLi; BLj) eine feste Betriebsspannung an das Speicherzellenfeld liefert wobei:
- zwischen dem mit der Spannungs-Konstantreglereinrichtung (KR) verbundenen Eingang der Wort- und/oder Bitleitungen (WLi; BLj) und deren Ausgang ein Spannungsabfall auftritt,
- das Speicherzellenfeld in mehrere Speicherzellenblöcke (ZB1, ZB2) unterteilt ist und
- die Speicherzellenblöcke (ZB1, ZB2) von der Spannungs-Konstantreglereinrichtung (KR) mit jeweils voneinander verschiedenen festen Betriebsspannungen versorgt sind,
**dadurch gekennzeichnet, daß**
- die Spannungs-Konstantreglereinrichtung (KR) aus mehreren Spannungs-Konstantreglern (KR1, KR2) besteht und jedem Speicherzellenblock (ZB1, ZB2) jeweils ein Spannungs-Konstantregler (KR1, KR2) zugeordnet ist.

2. MRAM-Anordnung nach Anspruch 1,
**dadurch gekennzeichnet, daß** der Ausgang der Wort- und/oder Bitleitungen (WLi, BLj) eines ersten Speicherzellenblockes (ZB1) als Spannungsversorgung mit dem Eingang des Spannungs-Konstantreglers (KR2) eines zweiten Speicherzellenblockes (ZB2) verbunden ist.

3. MRAM-Anordnung nach Anspruch 1 oder 2,
**dadurch gekennzeichnet, daß** zwischen jedem Spannungs-Konstantregler (KR1, KR2) und jedem Speicherzellenblock (ZB1, ZB2) jeweils ein gesteuerter Wortleitungstreiber (WT1, WT2) vorgesehen ist.
